# EUROPÄISCHE PATENTANMELDUNG

(11) **EP 4 063 016 A1**
(43) Veröffentlichungstag der Anmeldung: **28.09.2022**
(21) Anmeldenummer: 22161529.7
(22) Anmeldetag: 11.03.2022
(51) Int. Cl.: B05B 1/34, B05B 7/06, B05B 7/10, C23C 16/448, C23C 16/455, C23C 16/453, C23C 16/513, B05B 7/04

(54) **ZERSTÄUBERDÜSE**

(30) Priorität: 25.03.2021 DE 102021107482
(71) Anmelder: Verein zur Förderung von Innovationen durch Forschung, Entwicklung und Technologietransfer e.V. (Verein INNOVENT e.V.), 07745 Jena (DE)
(72) Erfinder: BEIER, Oliver, 07407 Rudolstadt (DE); MARTIN, Björn, 07745 Jena (DE); KÖCHER, Ronny, 99084 Erfurt (DE)
(74) Vertreter: Liedtke & Partner Patentanwälte

(57) **Zusammenfassung**

Die Erfindung betrifft eine Zerstäuberdüse (D), umfassend:
- eine rohrförmige Düsenlanze (6),
- einen Vortexgenerator (7), der in oder an einem freien Ende der Düsenlanze (6) angeordnet und zur Verwirbelung eines in der Düsenlanze (6) geführten Gasstroms ausgebildet ist,
- einen Düseneinsatz (8), der im Gasstrom stromabwärts in oder an dem freien Ende der Düsenlanze (6) oder in oder am Vortexgenerator (7) angeordnet ist und einen Hohlraum (8.2) aufweist,
wobei der Vortexgenerator (7) und der Düseneinsatz (8) jeweils eine zentrale Bohrung (7.1, 8.1) aufweisen, die zueinander koaxial angeordnet sind, wobei der Hohlraum (8.2) zur Weiterleitung des verwirbelten Gasstroms durch die zentrale Bohrung (8.1) des Düseneinsatzes (8) angeordnet ist,
- ein Röhrchen (9), das durch die zentralen Bohrungen (7.1, 8.1) geführt ist.

## Beschreibung

Die Erfindung betrifft eine Zerstäuberdüse.

Für die Zerstäubung von Flüssigkeiten im Allgemeinen sind verschiedene technische Zerstäuberprinzipien etabliert. Eine Übersicht findet sich beispielsweise in den Ausführungen von G. Wozniak, Zerstäubungstechnik - Prinzipien, Verfahren, Geräte; Springer-Verlag, 2003, ISBN 978-3-642-55835-1, https://doi .org/10.1007/978-3-642-55835-1. Unterschieden wird in folgende Zerstäuberprinzipien:
1) Einstoff-Druckdüsen:
   - Die Tropfenbildung erfolgt durch zugeführte Druckenergie auf die zu verdüsende Flüssigkeit.
   - Man unterscheidet zwischen strahlbildenden und filmbildenden Einstoff-Druckdüsen. Zu den strahlbildenden Düsen zählen beispielsweise Turbulenzdüsen, zu den filmbildenden Düsen die Lamellendüsen.
2) Zweistoffdüsen oder pneumatische Zerstäuber:
   - Die notwendige Energie zum Zerstäuben der Flüssigkeit wird durch die kinetische Energie eines Gases bereitgestellt.
   - Man unterscheidet nach dem Ort des Zusammentreffens der beiden Phasen zwischen Zweistoffdüsen innerer und äußerer Mischung.
3) Rotationszerstäuber:
   - Die zu zerstäubende Flüssigkeit wird mit hoher Geschwindigkeit aufgrund von Fliehkräften in die Umgebung geschleudert.
4) Ultraschall - Zerstäuber oder - Vernebler:
   - Hierbei wird die zu zerstäubende Flüssigkeit in Schwingung versetzt. Durch Ausbildung von Kapillarwellen werden bei ausreichend großer Schwingamplitude Tröpfchen aus der Flüssigkeit herausgeschleudert.
5) Sonderzerstäubungsverfahren:
   - Hierzu zählt insbesondere das elektrostatische Zerstäuben von Flüssigkeiten. Bei diesem Verfahren werden die abstoßenden Kräfte gleichpoliger Ladungen zum Zerteilen der Flüssigkeiten und Ausbildung kleiner Tröpfchen verwendet.

Der Erfindung liegt die Aufgabe zu Grunde, eine verbesserte Zerstäuberdüse anzugeben.

Die Aufgabe wird erfindungsgemäß gelöst durch eine Zerstäuberdüse mit den Merkmalen des Anspruchs 1.

Vorteilhafte Ausgestaltungen der Erfindung sind Gegenstand der Unteransprüche.

Eine erfindungsgemäße Zerstäuberdüse umfasst:
- eine rohrförmige Düsenlanze,
- einen Vortexgenerator, der in oder an einem freien Ende der Düsenlanze angeordnet und zur Verwirbelung eines in der Düsenlanze geführten Gasstroms ausgebildet ist,
- einen Düseneinsatz, der im Gasstrom stromabwärts in oder an dem freien Ende der Düsenlanze oder in oder am Vortexgenerator angeordnet ist und einen Hohlraum aufweist,
   wobei der Vortexgenerator und der Düseneinsatz jeweils eine zentrale Bohrung aufweisen, die zueinander koaxial angeordnet sind, wobei der Hohlraum zur Weiterleitung des verwirbelten Gasstroms durch die zentrale Bohrung des Düseneinsatzes angeordnet ist,
- ein Röhrchen, insbesondere einen Pumpschlauch oder eine Kanüle, das durch die zentralen Bohrungen geführt ist.

In einer Ausführungsform ist das Röhrchen in Längsrichtung durch die gesamte Zerstäuberdüse, insbesondere dessen übrige Komponenten, einschließlich der zentralen Bohrung im Düseneinsatz, geführt. Das Führen des Röhrchens durch die gesamte Zerstäuberdüse hat den Vorteil, dass die zu zerstäubenden Medien nicht mit der Zerstäuberdüse oder deren Komponenten, sondern lediglich mit dem Röhrchen, in Kontakt stehen. Daher besteht nicht die Gefahr des Verschmutzens der inneren Düsengeometrie, da das Medium erst am Düsenausgang mit dem Gas gemischt wird. Somit ergibt sich eine sehr hohe Langlebigkeit der Zerstäuberdüse.

In einer Ausführungsform ist das Röhrchen über seine gesamte Länge als eine einzige Komponente ausgebildet.

In einer Ausführungsform ist ein Grundkörper mit einer zumindest im Wesentlichen zylindrischen Aufnahmebohrung zur Aufnahme der Düsenlanze vorgesehen.

In einer Ausführungsform ist am Grundkörper ein Gasanschluss vorgesehen, der in die Aufnahmebohrung mündet, beispielsweise seitlich.

In einer Ausführungsform weist der Grundkörper eine Durchgangsbohrung auf, die mit der Aufnahmebohrung koaxial angeordnet ist und der Aufnahme des Röhrchens und/oder eines Führungsrohrs dient, in dem das Röhrchen geführt ist.

In einer Ausführungsform ist das Röhrchen in Längsrichtung durch die gesamte Zerstäuberdüse, einschließlich der zentralen Bohrung im Düseneinsatz und des Führungsrohrs, geführt.

In einer Ausführungsform ist am Grundkörper eine erste Fixierungseinrichtung für das Röhrchen vorgesehen. Diese ermöglicht, dass das Röhrchen entnommen und ausgewechselt werden kann. Somit kann das Röhrchen beispielsweise bei einer Verstopfung gewechselt werden. Ferner kann auf diese Weise ein Überstand des Röhrchens über den Düseneinsatz variiert werden.

In einer Ausführungsform ist eine zweite Fixierungseinrichtung zur Fixierung und Dichtung eines Endes der Düsenlanze im Grundkörper vorgesehen.

In einer Ausführungsform ist die zweite Fixierungseinrichtung als eine Überwurfmutter ausgebildet, die auf ein am Grundkörper vorgesehenes Gewinde geschraubt ist.

In einer Ausführungsform ist der Vortexgenerator im freien Ende der Düsenlanze eingeschraubt.

In einer Ausführungsform ist der Düseneinsatz im Vortexgenerator eingeschraubt.

In einer Ausführungsform ist das Führungsrohr durch die Durchgangsbohrung und die zentrale Bohrung des Vortexgenerators bis in den Hohlraum innerhalb des Düseneinsatzes geführt.

In einer Ausführungsform ist die erste Fixierungseinrichtung als eine Hohlschraube mit einer zentralen Bohrung ausgebildet, die in eine Einschraub-Bohrung im Grundkörper eingeschraubt oder einschraubbar ist, die koaxial mit der Durchgangsbohrung angeordnet ist, wobei die Einschraub-Bohrung ein sich verjüngendes Ende in Richtung der Durchgangsbohrung aufweist, wobei an einem dem Grundkörper zugewandtem Ende der ersten Fixierungseinrichtung ein Klemmkörper vorgesehen ist, der durch Einschrauben der ersten Fixierungseinrichtung in den Grundkörper im sich verjüngenden Ende der Einschraub-Bohrung um das Röhrchen herum zusammengepresst ist und diesen oder diese somit fixiert.

In einer Ausführungsform ist die erste Fixiereinrichtung als zwei Hohlschrauben mit jeweils einer zentralen Bohrung ausgebildet. Die erste Hohlschraube ist in eine Einschraub-Bohrung im Grundkörper eingeschraubt, wobei die erste Hohlschraube im Inneren ein Gewinde und einen Absatz aufweist, an dem ein oder mehrere Dichtungsringe (O-Ringe z.B. aus NBR oder Viton) positionierbar sind. Über eine zweite Hohlschraube, die in das Innengewinde der ersten Hohlschraube einschraubbar ist, werden die Dichtungsringe um das Röhrchen herum zusammengepresst und diese somit in der Zerstäuberdüse fixiert.

In einer Ausführungsform liegt ein Außendurchmesser des Röhrchens im Bereich von 0,3 mm bis 10,0 mm, insbesondere zwischen 0,6 mm und 3,0 mm.

In einer Ausführungsform liegt ein Innendurchmesser des Röhrchens im Bereich von 0,1 mm bis 7,0 mm, insbesondere zwischen 0,1 mm und 2,0 mm.

In einer Ausführungsform ist die zweite Fixierungseinrichtung mit magnetischen Eigenschaften und/oder mit einer Klemmvorrichtung ausgestattet, um die Zerstäuberdüse in einer definierten, festen Position innerhalb einer Sprühkammer oder Dosiereinheit zu halten.

Gemäß einem Aspekt der vorliegenden Erfindung kann eine Anordnung zum Eindosieren eines Precursors in einen Gasstrom vorgesehen sein, umfassend die oben beschriebene Zerstäuberdüse und eine Dosiereinheit, insbesondere eine Dosiereinheit gemäß EP 2 743 373 B1, wobei die Dosiereinheit einen massiv ausgebildeten Basiskörper mit einem ersten Kanal umfasst, der von einem Gaseintritt zu einem Gasaustritt von einem Gasstrom durchströmbar und als eine Bohrung in den Basiskörper eingebracht ist, wobei im Basiskörper ein zweiter Kanal angeordnet ist, der den ersten Kanal unter einem Winkel an einem Kreuzungspunkt schneidet, wobei die Zerstäuberdüse zum Zuführen des Precursors in den Gasstrom im zweiten Kanal angeordnet ist, wobei in einer Gebrauchslage der Dosiereinheit unterhalb des Kreuzungspunktes ein Ende des zweiten Kanals als eine Partikelfalle ausgebildet ist, wobei eine mit einem Verschlussstopfen verschließbare Reinigungsöffnung für die Partikelfalle vorgesehen ist.

Gemäß einem Aspekt der vorliegenden Erfindung kann die Zerstäuberdüse zum Zerstäuben verschiedener Medien, wie einer Flüssigkeit, eines Flüssigkeitsgemisches, einer Lösung, einer Dispersion, Suspension oder Emulsion verwendet werden, die im Röhrchen geführt wird. Das Medium wird dabei in einem aus der zentralen Bohrung des Düseneinsatzes austretenden Gasstrom zerstäubt, wobei das zerstäubte Medium in einem Verfahren zur chemischen und/oder physikalischen Gasphasenabscheidung, für die Sprühpyrolyse, für den Sprühauftrag von Lacken, Primern, Sol-Gel-Ansätzen, Klebstoffen, für Elektrospinning, für Suspension-Plasmaspritzen, für die Sprühtrocknung (Zerstäubungstrocknung) zur Erzeugung feiner Pulver oder allgemein für die Aerosolerzeugung z.B. für Luftbefeuchter, Klimakammern, Salzsprühkammern, Atomabsorptionsspektrometrie (z.B. F-AAS), Atomemissionsspektrometrie (z.B. F-AES, ICP-OES) verwendet wird.

Das hier neu entwickelte Düsensystem zählt zu den Zweistoffdüsen mit äußerer Mischung.

Ein solcher Düsentyp ist besonders für Beschichtungsprozesse und hierbei insbesondere für die chemische Gasphasenabscheidung (CVD) und deren Spezialfälle PECVD, APPCVD, CCVD geeignet.

Neben Verdampfersystemen zählen Zerstäuber zu den bevorzugt angewandten Methoden zur Precursorbereitstellung im Bereich der CVD bzw. allgemein Dünnschichttechnik (z.B. Sol-Gel-Applikationen).

Ausführungsbeispiele der Erfindung werden im Folgenden anhand von Zeichnungen näher erläutert.

Darin zeigen:
- Figur 1: ist eine schematische Ansicht einer Zerstäuberdüse,
- Figur 2: ist eine weitere schematische Ansicht der Zerstäuberdüse,
- Figur 3: ein schematisches Diagramm zur Darstellung von volumengewichteten Tröpfchenverteilungen von vier Aerosolarten für Drücke von 1 bar bis 6 bar,
- Figur 4: ein schematisches Diagramm zur Darstellung der volumengewichteten Tröpfchenverteilungen für Drücke von 1 bar bis 6 bar am Ausgang einer Sprühkammer für die Precursoren TEOS und Zinknitrat,
- Figur 5: ein schematisches Diagramm zur Darstellung der Ethanolkonzentration in einer Gasmesszelle in Abhängigkeit von einer Ethanol-Durchflussrate an der Zerstäuberdüse,
- Figur 6: ein schematisches Diagramm zur Darstellung einer Gaskonzentration in Abhängigkeit von einer Messzeit innerhalb einer Gasmesszelle für Ethanol-Durchflussraten von 2 µl/min und 7 µl/min an der Zerstäuberdüse, und
- Figur 7: ein schematisches Diagramm zur Darstellung von Schichtdicken in Abhängigkeit von einem Beschichtungszeitpunkt zur Beurteilung der Langzeit-Dosierstabilität der Zerstäuberdüse.

Einander entsprechende Teile sind in allen Figuren mit den gleichen Bezugszeichen versehen.

Die Erfindung betrifft eine Zerstäuberdüse und ein Verfahren zur Überführung eines Mediums, beispielsweise einer Flüssigkeit, eines Flüssigkeitsgemisches, einer Lösung, einer Dispersion, Suspension oder Emulsion, insbesondere eines flüssigen Precursors, in feine Tröpfchen (Aerosolform) für die Anwendung bei Beschichtungsprozessen. Als Beschichtungsprozesse werden insbesondere die Dünnschichttechnologien APPCVD (plasmaunterstützte chemische Gasphasenabscheidung bei Atmosphärendruck) und CCVD (Combustion-CVD, auch Flammenbeschichtung genannt) verwendet. Die Zerstäuberdüse und/oder das Verfahren sind jedoch nicht auf diese beiden Prozesse beschränkt, sondern ebenso einsetzbar für die Sprühpyrolyse oder auch für Sprühauftrag von Lacken, Primern, Sol-Gel-Ansätzen, Klebstoffen oder allgemein flüssigen Chemikalien (Reinstoffe, Stoffgemische, Lösungen, Dispersionen, Suspensionen, Emulsionen), Niederdruck-Plasmabeschichtung (PECVD), atmosphärische Sputtertechniken, Suspension-Plasmaspritzen oder als Düse für das Elektrospinning. Die Zerstäuberdüse ermöglicht eine homogene Aerosolerzeugung über weite Bereiche an Durchflussraten, von etwa 0,1 µl/min bis zu 2000 ml/min je nach dem gewählten Röhrchen-Innendurchmesser.

Das Düsenprinzip ist somit geeignet, kleine Einzelsysteme, zum Beispiel atmosphärische Plasmajets, bis hin zu aufskalierten Plasma- oder Beflammungssystemen (Anlagenbreiten von mehreren Zentimetern bis Metern) mit Precursoren zu versorgen. Als Pumpentypen zur Förderung des Mediums in Richtung der Zerstäuberdüse kommen sämtliche Arten von Verdrängerpumpen in Frage, wobei bevorzugt Schlauchpumpen (Peristaltikpumpen) Anwendung finden. Weiterhin kann die Zerstäuberdüse auch pumpenlos betrieben werden, unter Ausnutzung des Venturi-Effektes. In diesem Fall besitzt die Zerstäuberdüse selbstansaugende Eigenschaften für das Medium (selbstansaugende Zweistoffdüse).

In der Zerstäuberdüse können prinzipbedingt alle gängigen Typen von Röhrchen, insbesondere Kanülen, (zum Beispiel aus Edelstahl, Messing, Aluminium, Glas, Keramik, Kunststoff), sowie Kunststoffschläuche (zum Beispiel Pumpschläuche aus PTFE, Silikon, PVC, Polypropylen, Polyolefin, Polyamid, Viton oder Tygon) fixiert werden, woraus sich insgesamt folgende Vorteile gegenüber dem Stand der Technik ergeben:
- kein oder minimiertes Pulsieren des zerstäubten Mediums, daher ist die Anpassung des Innendurchmessers des Röhrchens, beispielsweise eines Pumpschlauchs oder einer Kanüle, an die jeweilige Anwendung und/oder Durchflussrate möglich,
- Durchflussraten des Mediums über weite Dosierbereiche von 0,1 µl/min bis 2000 ml/min einstellbar,
- keine Änderung der Volumina während des Transports des Mediums, daher ist ein konstanter Innendurchmesser des Röhrchens vom Precursorgefäß über die Dosierpumpe bis zum Düsenausgang möglich,
- Es besteht die Möglichkeit, für jede Precursorsubstanz ein separates Röhrchensystem aufzubauen, vom Precursorgefäß über die Dosierpumpe bis zum Düsenausgang. Somit können Querkontaminationen in Anlagen oder Kontaminationen von den erzeugten APPCVD bzw. CCVD-Schichten vermieden werden. Es ist ein einfacher Wechsel der Aufbauten für andere Precursorsubstanzen unter Verwendung von ein und derselben Zerstäuberdüse möglich.
- kein Verschmutzen der inneren Düsengeometrie, da das Medium erst am Düsenausgang mit dem Gas gemischt wird. Dadurch ergibt sich eine sehr hohe Langlebigkeit der Zerstäuberdüse. Die Medien stehen nicht mit der Zerstäuberdüse oder deren Komponenten in Kontakt.
- Das Düsenprinzip ist somit auch für aggressive Chemikalien (zum Beispiel Säuren und/oder Basen, korrosive Medien) geeignet, insbesondere durch Auswahl eines geeigneten Röhrchenmaterials (z.B. PTFE, Edelstahl).
- Ein Betrieb der Zerstäuberdüse ist bis mindestens 8 bar Gasdruck möglich.

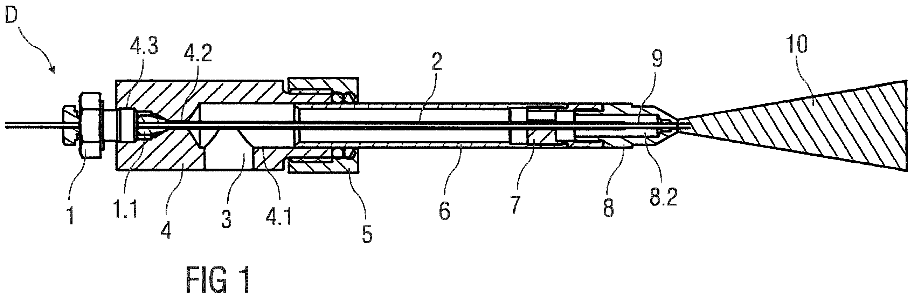

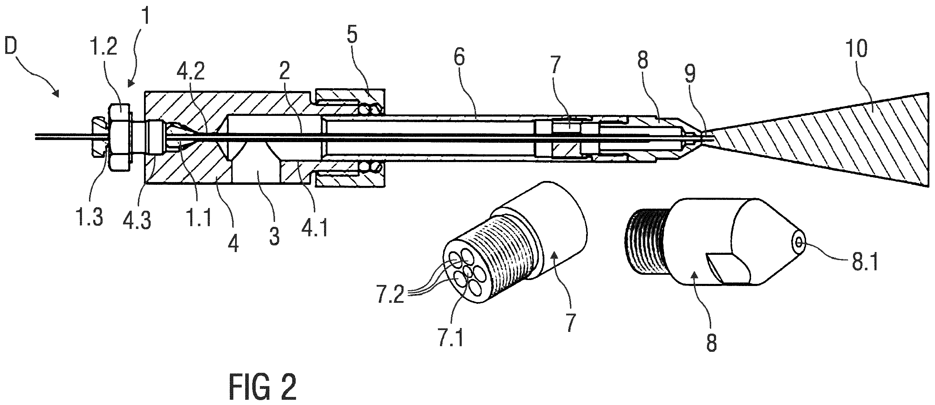

**Figur 1** ist eine schematische Ansicht der Zerstäuberdüse D. **Figur 2** ist eine weitere schematische Ansicht der Zerstäuberdüse D.

Die Zerstäuberdüse D umfasst eine erste Fixierungseinrichtung 1 für ein Röhrchen 9, beispielsweise einen Pumpschlauch 9 oder eine Kanüle 9, ein Führungsrohr 2, einen Gasanschluss 3, einen Grundkörper 4, eine zweite Fixierungseinrichtung 5 für eine Düsenlanze 6, einen Vortexgenerator 7, einen Düseneinsatz 8 und ein Röhrchen 9, beispielsweise einen Pumpschlauch 9 oder eine Kanüle 9. In **Figur 2** ist ferner ein aus der Zerstäuberdüse D austretender Sprühkegel 10 gezeigt.

Der Grundkörper 4 weist eine zumindest im Wesentlichen zylindrische Aufnahmebohrung 4.1 zur Aufnahme der Düsenlanze 6 auf. Der Gasanschluss 3 ist beispielsweise seitlich am Grundkörper 4 vorgesehen und mündet in die Aufnahmebohrung 4.1. Der Grundkörper 4 weist ferner eine Durchgangsbohrung 4.2 auf, die mit der Aufnahmebohrung 4.1 koaxial angeordnet sein, jedoch einen geringeren Durchmesser als diese aufweisen kann. Die Durchgangsbohrung 4.2 dient der Aufnahme des Führungsrohrs 2. Die zweite Fixierungseinrichtung 5 dient der Fixierung eines Endes der Düsenlanze 6 im Grundkörper 4 und ist beispielsweise als eine Überwurfmutter ausgebildet, die auf ein am Grundkörper 4 vorgesehenes Außengewinde geschraubt werden kann. In der zweiten Fixierungseinrichtung 5 kann mindestens eine Dichtung vorgesehen sein, die beim Festschrauben der zweiten Fixierungseinrichtung 5 gegen die Düsenlanze 6 dichtet und diese in der zweiten Fixierungseinrichtung 5 klemmt. Alternativ kann die Düsenlanze 6 an einer Seite mit einem Außengewinde und der Grundkörper 4 mit einem Innengewinde ausgestattet sein, um die Düsenlanze 6 in den Grundkörper 4 einzuschrauben. Im freien Ende der Düsenlanze 6 ist der Vortexgenerator 7 angeordnet, beispielsweise eingeschraubt. Stromabwärts vom Vortexgenerator 7 ist der Düseneinsatz 8 angeordnet, beispielsweise in den Vortexgenerator 7 eingeschraubt. Der Vortexgenerator 7 und der Düseneinsatz 8 weisen jeweils eine zentrale Bohrung 7.1, 8.1 auf, die mit der Durchgangsbohrung 4.2 koaxial angeordnet sind, wenn die Düsenlanze 6 im Grundkörper 4, der Vortexgenerator 7 in der Düsenlanze 6 und der Düseneinsatz 8 im Vortexgenerator 7 oder in der Düsenlanze 6 angeordnet ist. Das Führungsrohr 2 ist durch die Durchgangsbohrung 4.2 und die zentrale Bohrung 7.1 des Vortexgenerators 7 bis in einen Hohlraum 8.2 innerhalb des Düseneinsatzes 8 geführt. Das Führungsrohr 2 kann in der Durchgangsbohrung 4.2 und/oder in der zentralen Bohrung 7.1 im Vortexgenerator 7 fixiert sein, beispielsweise durch Einpressen.

Das Röhrchen 9 ist in Längsrichtung durch die gesamte Zerstäuberdüse D, das heißt durch das Führungsrohr 2 und die zentrale Bohrung 8.1 im Düseneinsatz 8, geführt und durch die erste Fixierungseinrichtung 1 durch Anpressen fixiert. Die erste Fixierungseinrichtung 1 kann als eine Hohlschraube mit einer zentralen Bohrung ausgebildet sein, die in eine Einschraub-Bohrung 4.3 eingeschraubt oder einschraubbar ist, die koaxial mit der Durchgangsbohrung 4.2 angeordnet ist. Die Einschraub-Bohrung 4.3 weist ein sich verjüngendes Ende in Richtung der Durchgangsbohrung 4.2 auf. An einem dem Grundkörper 4 zugewandten Ende der ersten Fixierungseinrichtung 1 ist ein Klemmkörper 1.1 vorgesehen, der beim Einschrauben der ersten Fixierungseinrichtung 1 in den Grundkörper 4 im sich verjüngenden Ende der Einschraub-Bohrung 4.3 um das Röhrchen 9 herum zusammengepresst wird und diesen oder diese somit fixiert. Weiterhin kann die erste Fixierungseinrichtung 1 als zwei Hohlschrauben mit jeweils einer zentralen Bohrung ausgebildet sein. Die erste Hohlschraube 1.2 ist in eine Einschraub-Bohrung 4.3 im Grundkörper 4 eingeschraubt, wobei die erste Hohlschraube 1.2 im Inneren ein Gewinde und einen Absatz aufweist, an dem ein oder mehrere Dichtungsringe (O-Ringe z.B. aus NBR oder Viton) positionierbar sind. Über eine zweite Hohlschraube 1.3, die in das Innengewinde der ersten Hohlschraube 1.2 einschraubbar ist, werden die Dichtungsringe um das Röhrchen 9 herum zusammengepresst und diese somit in der Zerstäuberdüse D fixiert.

Die Innendurchmesser der zentralen Bohrungen 7.1, 8.1 der ersten Fixierungseinrichtung 1, des Vortexgenerators 7 und des Düseneinsatzes 8 sowie des Führungsrohres 2 sind zum einen aufeinander und zum anderen auf den maximalen Außendurchmesser des Röhrchens 9 abgestimmt. Durch konstruktive Anpassungen, insbesondere Änderung des Innendurchmessers, dieser vier Teile lassen sich weitere Röhrchengeometrien verwenden. Dabei liegen die Außendurchmesser des Röhrchens 9 beispielsweise im Bereich von 0,3 mm bis 10,0 mm, besonders bevorzugt zwischen 0,6 mm und 3,0 mm. Die Innendurchmesser liegen beispielsweise entsprechend im Bereich von 0,1 mm bis 7,0 mm, besonders bevorzugt zwischen 0,1 mm und 2,0 mm. Der Gasanschluss 3 ermöglicht die Gasversorgung der Zerstäuberdüse D, wobei sämtliche Gase und Gasgemische Anwendung finden können. Besonders bevorzugt kann der Gasanschluss 3 und somit die Zerstäuberdüse D mit Druckluft, synthetischer Luft, Stickstoff, Argon, Helium oder Stickstoff-Wasserstoff-Gasgemischen (Formiergas) betrieben werden. Eine Integration der Zerstäuberdüse D in Sprühkammern oder Dosiereinheiten ist über die zweite Fixierungseinrichtung 5 oder die Düsenlanze 6 möglich. Die Dosiereinheit kann beispielsweise wie in EP 2 743 373 B1 ausgebildet sein, deren gesamter Inhalt hiermit durch Verweis einbezogen wird.

Dabei kann die zweite Fixierungseinrichtung 5 beispielsweise mit magnetischen Eigenschaften ausgestattet sein und so die Zerstäuberdüse D in einer definierten, festen Position innerhalb einer Sprühkammer oder Dosiereinheit gehalten werden. Beispielsweise weist die zweite Fixierungseinrichtung 5 ein permanentmagnetisches Material oder ein magnetisierbares Material auf, das von einem an der Sprühkammer oder Dosiereinheit angeordneten Permanentmagneten gehalten sein oder werden kann.

Dies ermöglicht auch eine einfache Installation oder Entnahme der Zerstäuberdüse D. An der Düsenlanze 6 kann eine konstruktive Halterung vorgesehen sein (beispielsweise über Dichtungsringe, wobei gleichzeitig Gas- / Flüssigkeitsdichtheit am Übergang zur Sprühkammer möglich ist) oder die Zerstäuberdüse D kann über eine Klemmvorrichtung (beispielsweise einen Bajonettverschluss, ein Scharnier, ein Gewinde, eine Klemmringverschraubung oder eine Überwurfmutter) an der Sprühkammer oder Dosiereinheit fixiert werden.

Der Vortexgenerator 7 dient der gezielten Verwirbelung des über den Gasanschluss 3 eingeleiteten Gases, das durch die Aufnahmebohrung 4.1 und die Düsenlanze 6 bis zum Vortexgenerator 7 strömt. Der Vortexgenerator 7 weist zu diesem Zweck mindestens einen Kanal 7.2 auf, der radial von der zentralen Bohrung 7.1 beabstandet ist. Beispielsweise können zwei, drei, vier, fünf oder mehr Kanäle 7.2 vorgesehen sein, die gleichförmig um die zentrale Bohrung 7.1 herum angeordnet sein können. Der Kanal 7.2 kann beispielsweise als eine schräge, das heißt zur zentralen Bohrung 7.1 nicht parallele, Bohrung oder als Abschnitt einer Helix ausgebildet sein. Das Gas gelangt somit verwirbelt in den Hohlraum 8.2 des Düseneinsatzes 8 und durch dessen zentrale Bohrung 8.1. Am Ausgang des Düseneinsatzes 8, das heißt seiner zentralen Bohrung 8.1, wird ein durch das Röhrchen 9 gefördertes Medium, beispielsweise ein flüssiger Precursor, mit dem Gas gemischt, was in der Zerstäubung des Precursors und/oder der Bildung von Tröpfchen des Precursors im Gas und/oder der Bildung eines Aerosols des Precursors mit dem Gas resultiert. Der Düseneinsatz 8 kann bevorzugt als eine Vollkegeldüse konzipiert sein (Sprühbild entspricht einer Kreisfläche), kann jedoch auch als eine Hohlkegeldüse oder Flachstrahldüse ausgebildet sein. Der resultierende Sprühwinkel kann über die relative Positionierung des Röhrchens 9 zum Düseneinsatz 8 in Längsrichtung, über die Durchmesser der zentralen Bohrung 8.1 des Düseneinsatzes 8 und des Röhrchens 9, über eine Variation des Drucks des Gases und/oder des Gasflusses und/oder der Menge des Mediums und/oder über die Art des Mediums (beispielsweise dessen Viskosität) eingestellt werden. Die Sprühwinkel liegen beispielsweise zwischen 5° und 120°, besonders bevorzugt zwischen 10° und 60°.

Der Gasfluss kann je nach verwendetem Gasdruck (beispielsweise 1 bar bis 8 bar) und dem Innendurchmesser der Bohrung 8.1 im Düseneinsatz 8 (Spaltbreite im Vergleich zum Außendurchmesser des Röhrchens 9) beispielsweise zwischen 1 l/min und 100 l/min, besonders bevorzugt zwischen 2 l/min und 30 l/min, liegen.

Die Komponenten der Zerstäuberdüse D können aus allen geeigneten Materialien bestehen, beispielsweise Stahl, Edelstahl, Messing, Aluminium, Kunststoffen wie POM oder PTFE oder Glas / Keramik.

### Ausführungsbeispiele:

### a) Ausführungsbeispiel 1:

Mittels Streulichtmessungen erfolgte eine Analyse der von der Zerstäuberdüse D erzeugten Aerosole. Dafür fand ein Laserbeugungsspektrometer vom Typ HELOS KR-H2487 (Laserwellenlänge: 632,8 nm) Anwendung, in dessen Analysebereich die Aerosole eingesprüht wurden. Zur Auswertung des Messsignals wurde die Fraunhofer-Theorie genutzt. Die Zerstäuberdüse D wurde mit einer Kanüle 9 aus Edelstahl mit einem Außendurchmesser von 0,8 mm betrieben. Als Gas wurde Druckluft verwendet. Der Gasdruck an der Zerstäuberdüse D wurde von 1 bar bis 6 bar variiert. Als Testmedien dienten einerseits zwei Precusorflüssigkeiten für APPCVD- und CCVD-Beschichtungsprozesse, Tetraethoxysilan (TEOS) zur Erzeugung von Siliziumoxidschichten und gelöstes Zinknitrat (Lösungsmittel: H₂O / Isopropanol mit Vol. Anteil 1:1) für Zinkoxidschichten oder Kompositschichten, in die Zinkoxidpartikel eingelagert werden können (beispielsweise für Schichten mit antimikrobiellen Eigenschaften). Andererseits fanden die beiden Lösungsmittel destilliertes H₂O und eine H₂O / Isopropanol Mischung mit Vol. Anteil 1:1 Anwendung. Die Dosierung der Medien zur Zerstäuberdüse D erfolgte mit einer Schlauchpumpe und einer konstanten Durchflussrate von 100 µl/min.

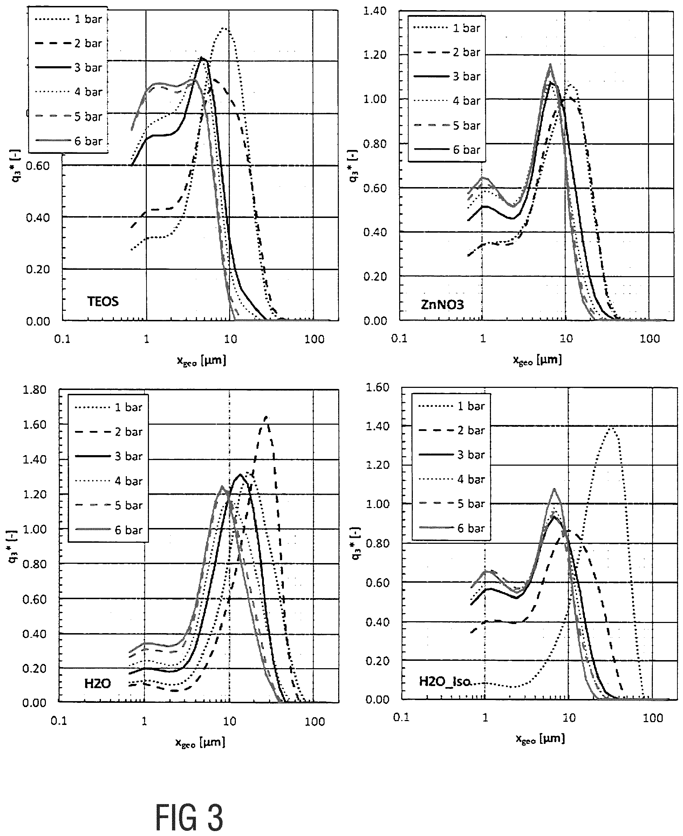

In **Figur 3** sind volumengewichtete Tröpfchenverteilungen der vier Aerosolarten für Drücke an der Zerstäuberdüse D von 1 bar bis 6 bar dargestellt. Dargestellt ist die volumengewichtete Tröpfchengrößenverteilung der primären Precursor-Aerosole an der Zerstäuberdüse D für die Precursoren TEOS (oben links), Zinknitrat (oben rechts) und die Lösungsmittel H₂O (unten links), H₂O / Isopropanol-Mischung mit Vol. Anteil 1:1 (unten rechts). Auf der Abszisse ist der geometrische Äquivalentdurchmesser x_{geo} in der Einheit µm aufgetragen. Die Ordinate enthält die transformierte Dichtefunktion der Größenverteilung qᵣ^{∗} und ist einheitenlos (r steht für die Mengenart, r=3 im Falle q₃^{∗} steht für die Partikelmasse).

Die Zerstäuberdüse D weist, wie für Zweistoffdüsen charakteristisch, eine bimodale Tröpfchengrößenverteilung auf. Das heißt, es liegen zwei Intensitätsmaxima vor. Mit steigendem Düsendruck werden für alle Testmedien die Tröpfchenverteilungen zu kleineren Partikelgrößen verschoben. Weiterhin steigen die Konzentrationen von Tröpfchen +≤ 1 µm signifikant an, die von besonderem Interesse für Beschichtungsprozesse sind.

### b) Ausführungsbeispiel 2:

Die Zerstäuberdüse D wird in diesem Beispiel mit einer Sprühkammer gemäß EP 2 743 373 B1 kombiniert. Der Aufbau und die gewählten Parameter der Zerstäuberdüse D sind identisch zum Ausführungsbeispiel 1. TEOS und gelöstes Zinknitrat stellen die beiden Testmedien dar. Eine Analyse der Tröpfchengrößenverteilung mittels Laserbeugungsspektrometer erfolgte diesmal am Ausgang der Sprühkammer (mit integrierter Zerstäuberdüse D).

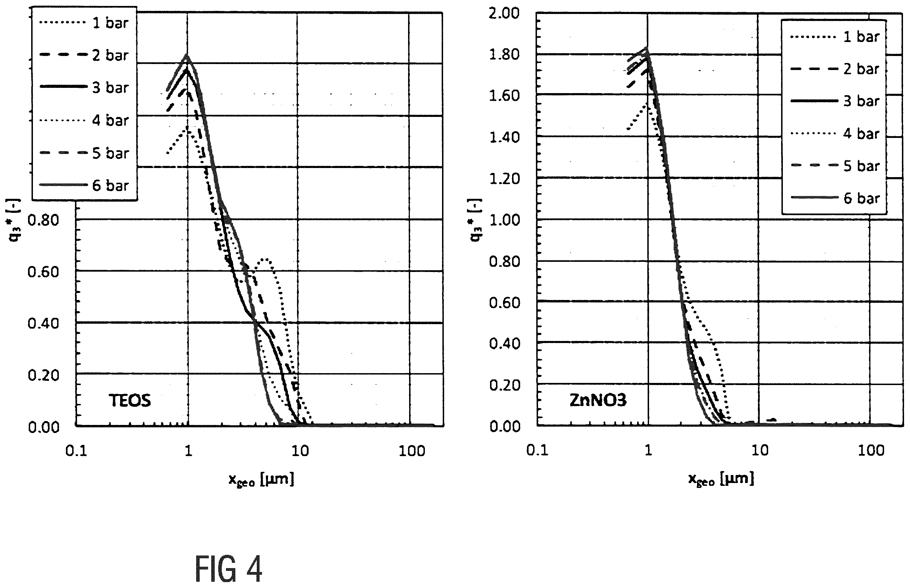

In **Figur 4** sind die volumengewichteten Tröpfchenverteilungen für Drücke an der Zerstäuberdüse D von 1 bar bis 6 bar am Ausgang der Sprühkammer gemäß EP 2 743 373 B1 für die Precursoren TEOS (links) und Zinknitrat (rechts) dargestellt.

Durch die Kombination aus Sprühkammer und Zerstäuberdüse D wird eine monomodale Verteilung und eine Begrenzung der maximalen Tröpfchengrößen für beide Precursorarten erzielt, insbesondere bei hohen Drücken. Weiterhin findet eine Verschiebung der mittleren Tröpfchengrößen zu geringeren Werten (ca. 1 µm bei volumengewichteter Darstellung) statt. Auch in diesen Untersuchungen führt eine Erhöhung des Druckes von 1 bar bis 6 bar zu einem Anstieg der Konzentration von Tröpfchen ≤ 1 µm.

### c) Ausführungsbeispiel 3:

In diesem Beispiel erfolgten Untersuchungen zur Dosier-Stabilität der Zerstäuberdüse D, insbesondere beim Betrieb mit geringen Durchflussraten im Bereich von wenigen µl/min.

Innerhalb der Zerstäuberdüse D wurde diesmal ein Pumpschlauch 9 aus PTFE (Polytetrafluorethylen) mit Hilfe der ersten Fixierungseinrichtung 1 fixiert. Der Außendurchmesser des Pumpschlauches 9 beträgt 0,8 mm, der Innendurchmesser 0,3 mm. Als Testflüssigkeit diente Ethanol, welches über die Zerstäuberdüse D in ein Trägergas (Druckluft mit 15 l/min) eindosiert und in eine Gasmesszelle weitergeleitet wurde. Unter ständigem Durchfluss wird innerhalb der Gasmesszelle die Ethanol-Konzentration mit einem Gassensor vom Typ Dräger Pac 8000 OV-A (Messbereich: 0 - 300 ppm) analysiert. Es erfolgte eine Variation der Ethanol-Durchflussrate an der Zerstäuberdüse D zwischen 2,0 µl/min und 9,0 µl/min mittels einer Schlauchpumpe.

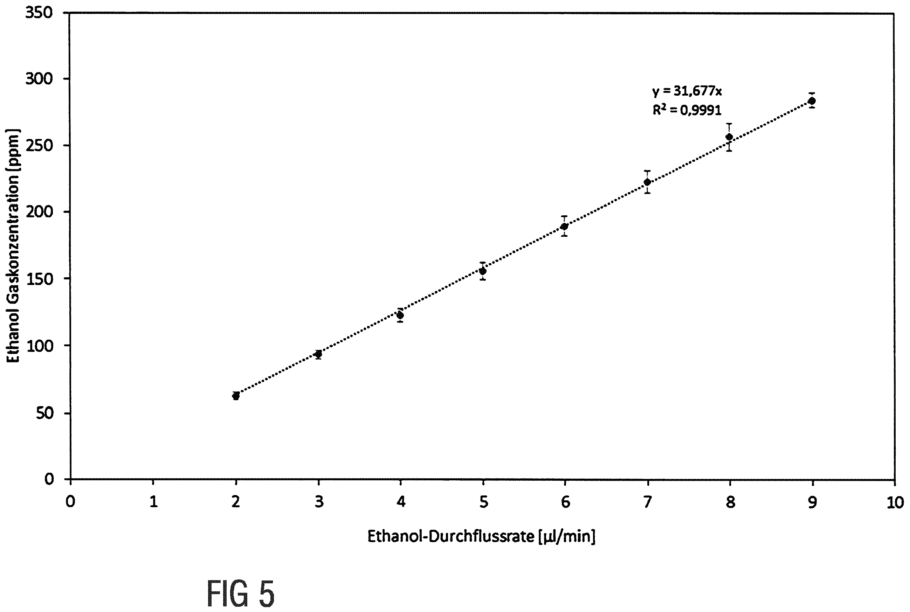

In **Figur 5** ist die Ethanolkonzentration in der Gasmesszelle in Abhängigkeit von der Ethanol-Durchflussrate an der Zerstäuberdüse D (zwischen 2,0 µl/min und 9,0 µl/min) dargestellt. Je Dosierrate wurde für fünf Minuten gemessen und dabei alle 30 Sekunden die Ethanolkonzentration dokumentiert. Die dargestellten Messwerte sind über sieben einzelne Messreihen gemittelt.

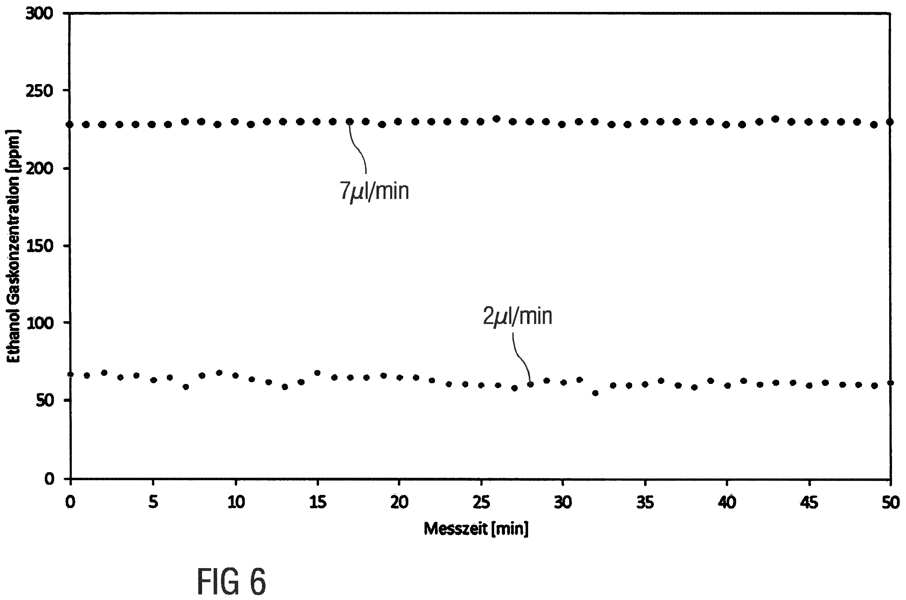

Im Ergebnis zeigt sich ein linearer Anstieg der Ethanolkonzentration in der Gasmesszelle mit der Ethanol-Durchflussrate. Eine Regressionsanalyse ergab für die Messdaten eine Geradengleichung von y = 31,677·x mit einem Bestimmtheitsmaß R² der linearen Regression von 0,9991. Selbst geringste Durchflussraten können mit der Zerstäuberdüse D homogen bereitgestellt werden. Über die sieben Messreihen lag der Variationskoeffizient (relative Standardabweichung) für alle getesteten Durchflussraten bei weniger als 5%. Die hohe Prozessstabilität wird auch in **Figur 6** verdeutlicht, wo über eine Messzeit von 50 Minuten die Gaskonzentration für Ethanol-Durchflussraten von 2 µl/min und 7 µl/min an der Zerstäuberdüse D gemessen wurde.

**Figur 6** zeigt ein Diagramm zur Darstellung der Gaskonzentration in Abhängigkeit von der Messzeit innerhalb einer Gasmesszelle für Ethanol-Durchflussraten von 2 µl/min und 7 µl/min an der Zerstäuberdüse D.

Hier lag der Variationskoeffizient für 2 µl/min bei 4,5% und für 7 µl/min bei 0,5 %. Hierbei sei angemerkt, dass die Messgenauigkeit des Gassensors mit ≤±20% des Messwertes angegeben wird und der Fehler bei niedrigen Gaskonzentrationen gegebenenfalls am oberen Ende der Fehlertoleranz liegt.

### d) Ausführungsbeispiel 4:

In diesem Beispiel erfolgten Versuche zur Abscheidung von SiOx - Dünnschichten mittels APPCVD und CCVD unter Verwendung der Zerstäuberdüse D und HMDSO (Hexamethyldisiloxan) als schichtbildender Ausgangssubstanz.

Für die Plasmaversuche (APPCVD) wurde ein kommerzieller Plasmajet vom Typ Plasma MEF (Tigres GmbH) eingesetzt. Als Precursor diente ein HMDSO / Isopropanol-Gemisch. Die Zerstäuberdüse D wird mit einer Sprühkammer gemäß EP 2 743 373 B1 kombiniert und der zerstäubte Precursor vom Ausgang der Sprühkammer zum Plasma geleitet. Die Zerstäuberdüse D wurde mit einer Kanüle 9 aus Edelstahl mit einem Außendurchmesser von 0,8 mm betrieben, die Precursor-Durchflussrate betrug 40 µl/min und der Gasdruck 4 bar. Als Gas wurde Druckluft verwendet.

Die Beschichtung erfolgte bei konstanten Plasmaparametern auf zuvor maskierten Glas-Objektträgern und Silizium-Wafern wie folgt:

### Beschichtungsparameter APPCVD

Plasmaleistung: 400 W
Prozessgas: Druckluft
Verfahrgeschwindigkeit der Substrate: 100 mm/s
Linienabstand: 3 mm
Anzahl Beschichtungsdurchläufe: 6

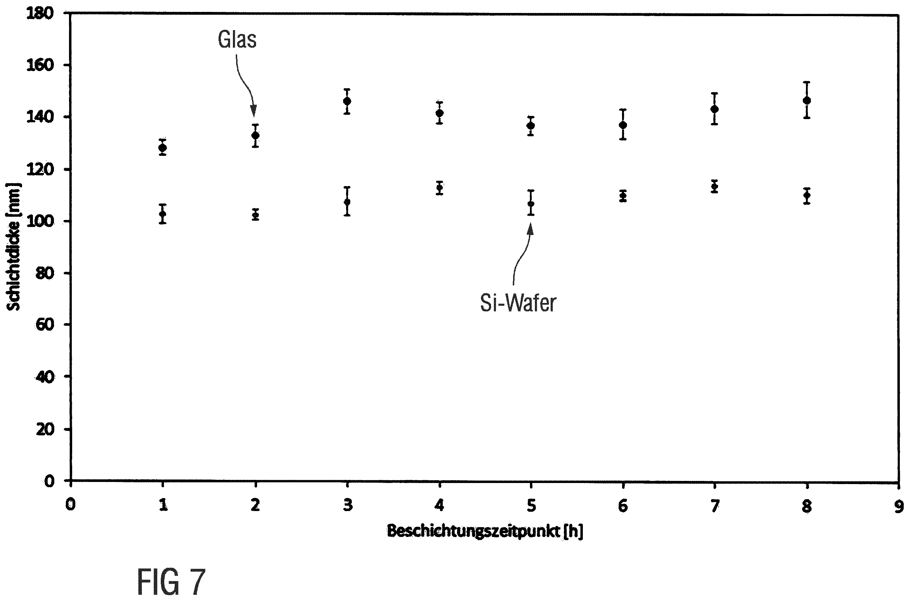

Bei dieser Versuchsserie wurde die Zerstäuberdüse D über einen Zeitraum von acht Stunden permanent betrieben um die Langzeit-Dosierstabilität zu beurteilen. Nach jeweils einer Stunde erfolgte die SiOx-Beschichtung der Substrate mit oben genannten Parametern. Ausgewertet wurde schließlich die Schichtdicke (Höhenunterschied: Schicht / Substrat) mit einem Profilometer Alpha-Step D-600 der Firma KLA Tencor nach Entfernung der Maskierung. In **Figur 7** sind die Ergebnisse dargestellt. **Figur 7** zeigt ein Diagramm zur Darstellung von Schichtdicken in Abhängigkeit von einem Beschichtungszeitpunkt zur Beurteilung der Langzeit-Dosierstabilität der Zerstäuberdüse D.

Es wurden insgesamt über die acht Stunden Dosierzeit für jeden der beiden Substrattypen nur geringe Schwankungen in den Schichtdicken ermittelt. Circa 130 nm bis 145 nm betrugen die Schichtdicken auf den Glassubstraten und 105 nm bis 115 nm auf den Si-Wafern. Ohne Berücksichtigung der Schwankungen des Plasmaprozesses ergab sich über die acht Stunden Dosierzeit ein Variationskoeffizient von kleiner 5 %.

Beim CCVD Prozess wurden mit der Zerstäuberdüse D Flammensysteme (Prozessgas: Propan / Luft-Gemisch) mit Beschichtungsbreiten zwischen 10 cm und 120 cm mit einem HMDSO-Precursor versorgt. Für einen 120 cm breiten Bandbrenner wurde die Zerstäuberdüse D mit einem als Kunststoffschlauch ausgebildeten Pumpschlauch 9 vom Typ Tygon und einem Außendurchmesser von 1,5 mm betrieben. Als Precursor diente ein HMDSO / Isopropanol-Gemisch, wobei die Precursor-Durchflussrate bei 6 ml/min lag.

Die Beschichtung erfolgte mit folgenden Parametern des Beflammungssystems auf zuvor maskiertem Floatglas (100 mm x 50 mm x 4 mm) an der Glas-Luftseite:

### Beschichtungsparameter CCVD

Brennerart: Bandbrenner 120 cm, 3-reihig
Propan / Luft Gemisch: 1/20
Verfahrgeschwindigkeit der Substrate: 50 mm/s
Anzahl Beschichtungsdurchläufe: 4

Nach Entfernung der Maskierung wurde die Schichtdicke mit einem Profilometer Alpha-Step D-600 der Firma KLA Tencor vermessen. Über die beschichtete Glasbreite wurde eine sehr hohe Gleichmäßigkeit festgestellt, die mittlere Schichtdicke lag im Bereich von ca. 50 nm.

### e) Ausführungsbeispiel 5:

Es folgt eine Auflistung weiterer APPCVD- und CCVD-Beschichtungen, die unter Einsatz der Zerstäuberdüse D realisiert wurden. Die Zerstäuberdüse D wurde entweder mit einer Kanüle 9 aus Edelstahl oder mit einem als PTFE-Schlauch ausgebildeten Pumpschlauch 9 (jeweils Außendurchmesser 0,8 mm) betrieben.
- Siliziumoxid, unter Verwendung von TEOS oder OMCTS (Octamethylcyclotetrasiloxan) als Precursor
- Titanoxid, unter Verwendung von TTIP (Titan (IV)-Isopropoxid), TBO (Titan (IV) Butoxid) oder TIPO (Titan (IV) Diisopropoxid-bis-(acetylacetonate)) als Precursor
- Zinnoxid, unter Verwendung von TBT (Tetrabutylzinn) oder Zinnchlorid (gelöst in HCl / Isopropanol Gemisch) als Precursor
- Zinkoxid, unter Verwendung von gelösten Zinknitrat, Zinkacetat, Zinksulfat, Zinkchlorid oder Zinkacetylacetonat als Precursor
- Wolframoxid unter Verwendung von Ammonium(meta)-wolframat, (gelöst in Methanol / Wasser - Gemisch)
- Aluminiumoxid unter Verwendung von Trimethylaluminium (TMA) oder gelösten Aluminiumnitrat, Aluminiumacetat, Aluminiumsulfat, Aluminiumchlorid, Aluminiumisopropoxid
- Zirkoniumoxid unter Verwendung von Zirkonium(IV)acetylacetonat, (gelöst in Ethanol / Wasser - Gemisch)
- Aminhaltige Schichten, unter Verwendung von Ethylendiamin oder Allylamin als Precursor
- Siliziumoxid-basierte Kompositschichten oder Mischschichten aus mehreren Elementen; Beispielhaft wurde HMDSO als Precursor für die Ausbildung des Siliziumoxids verwendet.
   ∘ SiOₓ / Ag (Precursor: gelöstes Silbernitrat oder Silber-Nanopartikel-Dispersionen)
   ∘ SiOₓ / Cu (Precursor: gelöstes Kupfernitrat, Kupferacetat, Kupfersulfat oder Kupferchlorid)
   ∘ SiOₓ / ZnO (Precursor: gelöstes Zinknitrat, Zinkacetat, Zinksulfat, Zinkchlorid, Zinkacetylacetonat oder Zink- bzw. Zinkoxid-Nanopartikel-Dispersionen)
   ∘ SiOₓ / Pd (Precursor: Palladiumchlorid gelöst in HCI / Isopropanol-Gemisch)
   ∘ SiOₓ / Ce (Precursor: gelöstes Cernitrat, Ceracetat, Cersulfat, Cerchlorid oder Cer- bzw. Ceroxid-Nanopartikel-Dispersionen)
   ∘ SiOₓ / Fe (Precursor: gelöstes Eisennitrat, Eisenacetat, Eisensulfat, Eisenchlorid, Ferrocen oder Eisenoxid-Nanopartikel-Dispersionen)
   ∘ SiOₓ / Ni (Precursor: gelöstes Nickelnitrat, Nickelacetat, Nickelsulfat, Nickelchlorid, Nickelacetylacetonat oder Nickel- bzw. Nickeloxid-Nanopartikel-Dispersionen
   ∘ SiOₓ / Fluoreszenzfarbstoff (Precursor: organische oder anorganische Farbstofflösungen, Farbstoff-Nanopartikel-Dispersionen)
   ∘ SiOₓ / Primer (Precursor: Kommerzielle Primersysteme wie SURALink^{®} 011, SURALink^{®} 021, SURALink^{®} 031 oder SURALink^{®} 041)
   ∘ SiOₓ / organische Stoffe (Precursoren entweder flüssig oder in gelöster Form: z.B. Polydimethylsiloxan (PDMS), Aminoalkylpolydimethylsiloxan, Quartäre Ammoniumverbindungen (z.B. Si-Quat), Weihrauch, Boswelliasäure, Gentamycin, Tryptanthrin, Benzoesäure, Thymol, Vanillin bzw. Vanillinsäure, Fumarsäure, Gelatine, Kollagen, Linalylacetat oder Permethrin)
   ∘ SiOₓ / TiOₓ Mischschichten (Precursor: TTIP, TBO oder TIPO)
   ∘ SiOₓ / SnOₓ Mischschichten (Precursor: TBT oder gelöstes Zinnchlorid)
   ∘ SiOₓ / Phosphat Mischschichten
- Titanoxid-basierte Kompositschichten oder Mischschichten aus mehreren Elementen; Beispielhaft wurde TIPO für die Ausbildung des Titanoxids verwendet.
   ∘ TiOₓ / Ag (Precursor: gelöstes Silbernitrat oder Silber-Nanopartikel-Dispersionen)
   ∘ TiOₓ / Cu (Precursor: gelöstes Kupfernitrat, Kupferacetat, Kupfersulfat oder Kupferchlorid)
   ∘ TiOₓ / ZnO (Precursor: gelöstes Zinknitrat, Zinkacetat, Zinksulfat, Zinkchlorid, Zinkacetylacetonat oder Zink- bzw. Zinkoxid-Nanopartikel-Dispersionen)
   ∘ TiOₓ / Stickstoff-Dotierung (Precursor: Ammoniak bzw. Ammoniakwasser oder gelöste Ammoniumsalze)
   ∘ TiOₓ / SnOₓ Mischschichten (Precursor: TBT oder gelöstes Zinnchlorid)
- Zinnoxid-basierte Kompositschichten oder Mischschichten aus mehreren Elementen; Beispielhaft wurde gelöstes Zinnchlorid für die Ausbildung des Zinnoxids verwendet.
   ∘ SnOₓ / Ag (Precursor: gelöstes Silbernitrat oder Silber-Nanopartikel-Dispersionen)
   ∘ SnOₓ / Cu (Precursor: gelöstes Kupfernitrat, Kupferacetat, Kupfersulfat oder Kupferchlorid)
   ∘ SnOₓ / Sb (Precursor: gelöstes Antimonchlorid - Sb(III)Cl₃)
- Weitere Komposit- oder Mischschichten können auf der Basis von Zinkoxid, Aluminiumoxid, Wolframoxid, Zirkoniumoxid, Molobdänoxid, Phosphaten, Nickeloxid, Eisenoxid und/oder Yttriumoxid (z.B. Yttrium-Eisen-Granat, Yttrium-Aluminium-Granat) als schichtbildende Komponente abgeschiedenen werden.

Darüber hinaus kann die Zerstäuberdüse D für Schichten nach dem Verfahren der Sprühpyrolyse eingesetzt werden, beispielsweise zur Applikation von Solen für die Ausbildung von Sol-Gel-Schichten. Dabei wird das zerstäubte Precursor-Aerosol auf ein beheiztes Substrat aufgebracht und durch die thermische Energie in die finale Schicht umgewandelt. Die Aufheizung des Substrates kann beispielsweise über Heizplatten, IR-Strahler, Plasmen, Flammen oder Laser erfolgen. Als Beispiele seien hier erwähnt:
- Zinnoxidschichten mit Zinnchlorid (gelöst in HCl / Isopropanol-Gemisch) als Precursor,
- Cu- oder Sb-dotierte Zinnoxidschichten - Beimischung von Sb(III)Cl₃ oder CuCl₂ zum zuvor genannten Zinnchlorid-Precursor,
- Siliziumoxidschichten mit TEOS oder TEOS-basierten Solen als Precursor,
- Titanoxidschichten mit TTIP oder TTIP-basierten Solen als Precursor.

### BEZUGSZEICHENLISTE

- D: Zerstäuberdüse
- 1: erste Fixierungseinrichtung
- 1.1: Klemmkörper
- 1.2: erste Hohlschraube
- 1.3: zweite Hohlschraube
- 2: Führungsrohr
- 3: Gasanschluss
- 4: Grundkörper
- 4.1: Aufnahmebohrung
- 4.2: Durchgangsbohrung
- 4.3: Einschraub-Bohrung
- 5: zweite Fixierungseinrichtung
- 6: Düsenlanze
- 7: Vortexgenerator
- 7.1: zentrale Bohrung
- 7.2: Kanal
- 8: Düseneinsatz
- 8.1: zentrale Bohrung
- 8.2: Hohlraum
- 9: Röhrchen, Pumpschlauch, Kanüle
- 10: Sprühkegel
- qᵣ^{∗}: transformierte Dichtefunktion der Größenverteilung
- R²: Bestimmtheitsmaß der linearen Regression
- x_{geo}: geometrischer Äquivalenzdurchmesser
- y: Geradengleichung

## Patentansprüche

1. Zerstäuberdüse (D), umfassend:
- eine rohrförmige Düsenlanze (6),
- einen Vortexgenerator (7), der in oder an einem freien Ende der Düsenlanze (6) angeordnet und zur Verwirbelung eines in der Düsenlanze (6) geführten Gasstroms ausgebildet ist,
- einen Düseneinsatz (8), der im Gasstrom stromabwärts in oder an dem freien Ende der Düsenlanze (6) oder in oder am Vortexgenerator (7) angeordnet ist und einen Hohlraum (8.2) aufweist,
wobei der Vortexgenerator (7) und der Düseneinsatz (8) jeweils eine zentrale Bohrung (7.1, 8.1) aufweisen, die zueinander koaxial angeordnet sind, wobei der Hohlraum (8.2) zur Weiterleitung des verwirbelten Gasstroms durch die zentrale Bohrung (8.1) des Düseneinsatzes (8) angeordnet ist,
- ein Röhrchen (9), das durch die zentralen Bohrungen (7.1, 8.1) geführt ist.

2. Zerstäuberdüse (D) nach Anspruch 1, wobei das Röhrchen in Längsrichtung durch die gesamte Zerstäuberdüse (D), einschließlich der zentralen Bohrung (8.1) im Düseneinsatz (8), geführt ist.

3. Zerstäuberdüse (D) nach Anspruch 1 oder 2, wobei ein Grundkörper (4) mit einer zumindest im Wesentlichen zylindrischen Aufnahmebohrung (4.1) zur Aufnahme der Düsenlanze (6) vorgesehen ist.

4. Zerstäuberdüse (D) nach Anspruch 3, wobei am Grundkörper (4) ein Gasanschluss (3) vorgesehen ist, der in die Aufnahmebohrung (4.1) mündet.

5. Zerstäuberdüse (D) nach Anspruch 3 oder 4, wobei der Grundkörper (4) eine Durchgangsbohrung (4.2) aufweist, die mit der Aufnahmebohrung (4.1) koaxial angeordnet ist und der Aufnahme des Röhrchens (9) und/oder eines Führungsrohrs (2) dient, in dem das Röhrchen (9) geführt ist.

6. Zerstäuberdüse (D) nach einem der Ansprüche 3 bis 5, wobei am Grundkörper (4) eine erste Fixierungseinrichtung (1) für das Röhrchen (9) vorgesehen ist.

7. Zerstäuberdüse (D) nach einem der Ansprüche 3 bis 6, wobei eine zweite Fixierungseinrichtung (5) zur Fixierung und Dichtung eines Endes der Düsenlanze (6) im Grundkörper (4) vorgesehen ist.

8. Zerstäuberdüse (D) nach einem der vorhergehenden Ansprüche, wobei der Vortexgenerator (7) im freien Ende der Düsenlanze (6) eingeschraubt ist.

9. Zerstäuberdüse (D) nach einem der vorhergehenden Ansprüche, wobei der Düseneinsatz (8) im Vortexgenerator (7) eingeschraubt ist.

10. Zerstäuberdüse (D) nach einem der Ansprüche 5 bis 9, wobei das Führungsrohr (2) durch die Durchgangsbohrung (4.2) und die zentrale Bohrung (7.1) des Vortexgenerators (7) fixiert und bis in den Hohlraum (8.2) innerhalb des Düseneinsatzes (8) geführt ist.

11. Zerstäuberdüse (D) nach einem der Ansprüche 6 bis 10, wobei die erste Fixierungseinrichtung (1) als eine Hohlschraube mit einer zentralen Bohrung ausgebildet ist, die in eine Einschraub-Bohrung (4.3) im Grundkörper (4) eingeschraubt oder einschraubbar ist, die koaxial mit der Durchgangsbohrung (4.2) angeordnet ist, wobei die Einschraub-Bohrung (4.3) ein sich verjüngendes Ende in Richtung der Durchgangsbohrung (4.2) aufweist, wobei an einem dem Grundkörper (4) zugewandten Ende der ersten Fixierungseinrichtung (1) ein Klemmkörper (1.1) vorgesehen ist, der durch Einschrauben der ersten Fixierungseinrichtung (1) in den Grundkörper (4) im sich verjüngenden Ende der Einschraub-Bohrung (4.3) um das Röhrchen (9) herum zusammengepresst ist und diesen oder diese somit fixiert, oder wobei die erste Fixiereinrichtung (1) eine erste (1.2) und eine zweite (1.3) Hohlschraube mit jeweils einer zentralen Bohrung umfasst, wobei die erste Hohlschraube (1.2) in eine Einschraub-Bohrung (4.3) im Grundkörper (4) eingeschraubt ist, wobei die erste Hohlschraube (1.2) im Inneren ein Gewinde und einen Absatz aufweist, an dem ein oder mehrere Dichtungsringe positionierbar sind, wobei die Dichtungsringe mittels der zweiten Hohlschraube (1.3), die in das Innengewinde der ersten Hohlschraube (1.2) einschraubbar oder eingeschraubt ist, um das Röhrchen (9) herum zusammengepresst und diese somit in der Zerstäuberdüse (D) fixiert sind.

12. Zerstäuberdüse (D) nach einem der vorhergehenden Ansprüche, wobei der Außendurchmesser des Röhrchens (9) im Bereich von 0,3 mm bis 10,0 mm, insbesondere zwischen 0,6 mm und 3,0 mm, liegt und/oder wobei der Innendurchmesser des Röhrchens (9) im Bereich von 0,1 mm bis 7,0 mm, insbesondere zwischen 0,1 mm und 2,0 mm, liegt.

13. Zerstäuberdüse (D) nach einem der Ansprüche 7 bis 12, wobei die zweite Fixierungseinrichtung (5) mit magnetischen Eigenschaften und/oder die Düsenlanze (6) mit einer Klemmvorrichtung ausgestattet ist um die Zerstäuberdüse (D) in einer definierten, festen Position innerhalb einer Sprühkammer oder Dosiereinheit zu halten.

14. Anordnung zum Eindosieren eines Precursors in einen Gasstrom, umfassend die Zerstäuberdüse (D) nach einem der vorhergehenden Ansprüche und eine Dosiereinheit, wobei die Dosiereinheit einen massiv ausgebildeten Basiskörper mit einem ersten Kanal umfasst, der von einem Gaseintritt zu einem Gasaustritt von einem Gasstrom durchströmbar und als eine Bohrung in den Basiskörper eingebracht ist, wobei im Basiskörper ein zweiter Kanal angeordnet ist, der den ersten Kanal unter einem Winkel an einem Kreuzungspunkt schneidet, wobei die Zerstäuberdüse (D) zum Zuführen des Precursors in den Gasstrom im zweiten Kanal angeordnet ist, wobei in einer Gebrauchslage der Dosiereinheit unterhalb des Kreuzungspunktes ein Ende des zweiten Kanals als eine Partikelfalle ausgebildet ist, wobei eine mit einem Verschlussstopfen verschließbare Reinigungsöffnung für die Partikelfalle vorgesehen ist.

15. Verwendung der Zerstäuberdüse (D) nach einem der Ansprüche 1 bis 13 zum Zerstäuben eines Mediums, das im Röhrchen (9) geführt wird, in einem aus der zentralen Bohrung (8.1) des Düseneinsatzes (8) austretenden Gasstrom, wobei die Durchflussrate des Mediums zwischen 0,1 µl/min und 2000 ml/min liegt und das zerstäubte Medium in einem Verfahren zur chemischen Gasphasenabscheidung, physikalischen Gasphasenabscheidung, für die Sprühpyrolyse, für den Sprühauftrag von Lacken, Primern, Sol-Gel-Ansätzen, Klebstoffen, für Elektrospinning, für Suspension-Plasmaspritzen, für die Sprühtrocknung zur Erzeugung feiner Pulver oder allgemein für die Aerosolerzeugung verwendet wird.
